# EUROPÄISCHE PATENTSCHRIFT

(11) **EP 1 463 951 B1**
(45) Veröffentlichungstag und Bekanntmachung des Hinweises auf die Patenterteilung: **16.04.2008**
(21) Anmeldenummer: 02799713.9
(22) Anmeldetag: 19.12.2002
(51) Int. Cl.: G01R 33/385

(54) **MAGNETRESONANZGERÄT MIT EINEM WIRBELSTROMERZEUGER**
MAGNETIC RESONANCE DEVICE COMPRISING AN EDDY-CURRENT GENERATOR
APPAREIL A RESONANCE MAGNETIQUE COMPRENANT UN GENERATEUR DE COURANTS DE FOUCAULT

(30) Priorität: 11.01.2002 DE 10200861
(43) Veröffentlichungstag der Anmeldung: 06.10.2004
(73) Patentinhaber: SIEMENS AKTIENGESELLSCHAFT, 80333 München (DE)
(72) Erfinder: DIETZ, Peter, 90449 Nürnberg (DE)
(86) Internationale Anmeldenummer: PCT/DE2002/004675
(87) Internationale Veröffentlichungsnummer: WO 2003/058265

(56) Entgegenhaltungen:
- US-A- 5 617 026
- J. QIU, J. TANI: "Vibration control of a cylindrical shell ..." SMART MATER. STRUCT., Bd. 4, 1995, Seiten 75-81, XP002241256
- PATENT ABSTRACTS OF JAPAN vol. 1998, no. 04, 31. März 1998 (1998-03-31) & JP 09 308617 A (HITACHI MEDICAL CORP), 2. Dezember 1997 (1997-12-02)

## Beschreibung

Die Erfindung betrifft ein Magnetresonanzgerät.

Die Magnetresonanztechnik ist eine bekannte Technik unter anderem zum Gewinnen von Bildern eines Körperinneren eines Untersuchungsobjekts. Dazu werden in einem Magnetresonanzgerät einem statischen Grundmagnetfeld, das von einem Grundfeldmagneten erzeugt wird, schnell geschaltete Gradientenfelder überlagert, die von einem Gradientenspulensystem erzeugt werden. Ferner umfasst das Magnetresonanzgerät ein Hochfrequenzsystem, das zum Auslösen von Magnetresonanzsignalen Hochfrequenzsignale in das Untersuchungsobjekt einstrahlt und die erzeugten Magnetresonanzsignale aufnimmt, auf deren Basis Magnetresonanzbilder erstellt werden.

Ein supraleitender Grundfeldmagnet umfasst beispielsweise einen im Wesentlichen hohlzylinderförmigen Heliumbehälter, in dem supraleitende Spulen angeordnet sind, die von dem sie umgebenden flüssigen Helium gekühlt werden. Der Heliumbehälter ist von einem hohlzylinderförmigen inneren Kälteschild umschlossen, das wiederum von einem hohlzylinderförmigen äußeren Kälteschild umschlossen ist. Die Kälteschilde bewirken dabei, dass möglichst wenig Wärmestrahlung bis zum Heliumbehälter vordringt. Dazu sind die Kälteschilde aus einem gut wärmeleitenden Metall, beispielsweise Aluminium, ausgebildet. Die Kälteschilde und/oder der Heliumbehälter werden dabei durch Kryokühler, Kaltgas oder flüssigen Stickstoff auf vorgebbaren Temperaturen gehalten. Das äußere Kälteschild ist schließlich von einem im Wesentlichen hohlzylinderförmigen Vakuumbehälter umschlossen. Die Behälter sind dabei in der Regel aus unmagnetischem rostfreien Stahl ausgebildet. Der Heliumbehälter ist mit dem inneren Kälteschild, die beiden Kälteschilde sind untereinander und das äußere Kälteschild ist mit dem Vakuumbehälter schlecht wärmeleitend auf einen gegenseitigen Abstand von einigen Millimetern bis zu wenigen Zentimetern verbunden.

In der zylinderförmigen Höhlung des Vakuumbehälters ist ein hohlzylinderförmiges Gradientenspulensystem, beispielsweise durch Verkeilen in der Höhlung, befestigt. Zum Erzeugen von Gradientenfeldern sind in Gradientenspulen des Gradientenspulensystems entsprechende Ströme einzustellen. Dabei betragen die Amplituden der erforderlichen Ströme bis zu mehreren 100 A. Die Stromanstiegs- und -abfallraten betragen bis zu mehreren 100 kA/s. Auf diese sich zeitlich verändernden Ströme in den Gradientenspulen wirken bei vorhandenem Grundmagnetfeld in der Größenordnung von 1 T Lorentzkräfte, die zu Schwingungen des Gradientenspulensystems und damit zu an sich unerwünschten akustischen Geräuschen und Bildqualitätsstörungen führen.

Beispielsweise in der DE 44 32 747 A1 ist eine prinzipielle Verringerung von Schwingungen des Gradientenspulensystems durch eine aktive Maßnahme beschrieben. Dazu ist in oder am Gradientenspulensystem eine Einrichtung, insbesondere beinhaltend elektrostriktive Elemente, angeordnet. Mit dieser Einrichtung können Kräfte erzeugt werden, die den Schwingungen des Gradientenspulensystems entgegenwirken, so dass ein Verformen des Gradientenspulensystems im wesentlichen verhindert wird. Die elektrostriktiven Elemente werden dazu durch eine an sie angelegte elektrische Spannung entsprechend gesteuert.

Das Gradientenspulensystem ist in der Regel von leitfähigen Strukturen umgeben, in denen durch die geschalteten Gradientenfelder Wirbelströme induziert werden. Beispiele für derartige leitfähige Strukturen sind der Vakuumbehälter und/oder die Kälteschilde des supraleitenden Grundfeldmagneten, ein Hochfrequenzschirm, beispielsweise aus einer Kupferfolie, und eine Antenne des Hochfrequenzsystems. Die mit den Wirbelströmen einhergehenden Felder sind unerwünscht, weil sie die Gradientenfelder ohne gegensteuernde Maßnahmen schwächen und in ihrem zeitlichen Verlauf verzerren, was zur Beeinträchtigung der Qualität von Magnetresonanzbildern führt.

Das Verzerren eines Gradientenfeldes infolge der Wirbelstromfelder kann bis zu einem gewissen Grad durch ein entsprechendes Vorverzerren einer das Gradientenfeld steuernden Größe kompensiert werden. Zum Kompensieren ist die steuernde Größe dabei derart zu filtern, dass die bei nicht-vorverzerrtem Betreiben der Gradientenspule auftretenden Wirbelstromfelder, durch das Vorverzerren aufgehoben werden. Zum Filtern ist ein Filternetzwerk einsetzbar, dessen Größen durch Zeitkonstanten und Koeffizienten bestimmt sind, die beispielsweise mit einem Verfahren entsprechend der DE 198 59 501 C1 ermittelbar sind.

Durch einen Einsatz eines aktiv geschirmten Gradientenspulensystems sind ferner die auf einer vorgebbaren Hüllfläche, die beispielsweise durch den inneren Zylindermantel des 80-K-Kälteschilds des supraleitenden Grundfeldmagneten verläuft, durch die bestromten Gradientenspulen induzierten Wirbelströme reduzierbar.

Des weiteren ist beispielsweise aus der DE 198 43 905 A1 ein mit Trennschlitzen versehener Hochfrequenzschirm für ein Magnetresonanzgerät bekannt, wobei der Hochfrequenzschirm unter anderem derart geschlitzt ist, dass die von den Gradientenfeldern im Hochfrequenzschirm induzierten Wirbelströme möglichst unterdrückt werden.

Eine Aufgabe der Erfindung ist es, ein verbessertes Magnetresonanzgerät zu schaffen, bei dem unter anderem an sich unerwünschte Wirbelstromeffekte besser beherrscht werden.

Die Aufgabe wird durch den Gegenstand des Anspruchs 1 gelöst. Vorteilhafte Ausgestaltungen sind in den Unteransprüchen beschrieben.

Gemäß Anspruch 1 ist bei einem Magnetresonanzgerät mit
- einem Grundfeldmagneten zum Erzeugen eines Grundmagnetfeldes,
- wenigstens einem Wirbelstromerzeuger und
- wenigstens einer elektrisch leitfähigen Struktur, in der durch den Wirbelstromerzeuger Wirbelströme hervorrufbar sind, so dass auf die Struktur im Grundmagnetfeld Lorentzkräfte wirken,
an der Struktur ein Krafterzeuger angebracht, der derart ausgebildet und steuerbar ist, dass mit dem Krafterzeugen den Lorentzkräften entgegenwirkende Kräfte erzeugt werden, so dass ein Bewegen und Verformen der Struktur verhindert wird.

Die Erfindung geht dabei von folgender Erkenntnis aus: Durch die geschalteten Gradientenfelder werden in einer leitfähigen Struktur Wirbelströme induziert, auf die ihrerseits im Grundmagnetfeld Lorentzkräfte wirken, so dass auch die leitfähige Struktur zum Schwingen angeregt wird, was zur Induktion weiterer Wirbelströme und damit einhergehend zu weiteren Schwingungen usw. führt. Sobald aber die leitfähige Struktur ins Schwingen gerät, ist eine Bekämpfung dieser Schwingungen nur noch über eine ausgefeilte Sensor-Aktor-Kombination möglich, da diese Schwingungen von einem Resonanzverhalten der leitfähigen Struktur abhängen und durch die weiteren Wirbelströme mitbestimmt werden. Gemäß der Erfindung wird vorgenannte Komplexität vermieden, indem an der leitfähigen Struktur ein Krafterzeuger angebracht ist, der derart gestaltet ist, dass er Kräfte erzeugt, die denjenigen Kräften entgegenwirken, die auf die durch die Gradientenfelder erzeugten Wirbelströme in der leitfähigen Struktur wirken. Ein Bewegen und/oder Schwingen der leitfähigen Struktur wird damit von vorneherein verhindert. Dabei ist von Vorteil, dass die Gradientenfelder räumlich konstant sind und direkt mit in den Gradientenspulen fließenden Strömen der einzelnen Gradientenachsen skalierbar sind, so dass die dadurch angeregten Wirbelströme auf exakt vorhersagbaren oder einmal zu messenden Bahnen verlaufen, die gegebenenfalls höchstens unterschiedliche Abklingkurven aufweisen. Dies eröffnet ferner die Möglichkeit einer einfachen Ansteuerung der Krafterzeuger, basierend auf einem zeitlichen Stromverlauf in den Gradientenspulen, wobei insbesondere ein Anteil zur wirbelstromkompensierenden Vorverzerrung einem Anteil und Zeitverlauf der Wirbelströme entspricht.

Weitere Vorteile, Merkmale und Einzelheiten der Erfindung ergeben sich aus nachfolgender Beschreibung von Ausführungsbeispielen der Erfindung anhand der Zeichnung. Dabei zeigen:
Figur 1 einen Längsschnitt durch ein Magnetresonanzgerät mit einem Gradientenspulensystem und einem Krafterzeuger,
Figur 2 ausschnittsweise einen detaillierten Längsschnitt durch den Krafterzeuger in einer ersten Ausführungsform,
Figur 3 ausschnittsweise einen detaillierten Längsschnitt durch den Krafterzeuger in einer zweiten Ausführungsform,
Figur 4 eine perspektivische Ansicht des Gradientenspulensystems mit vier Ringspulen zum Erfassen von Magnetfeldern des Gradientenspulensystems und
Figur 5 ausschnittsweise eine perspektivische Ansicht des Gradientenspulensystems mit einer flächendeckenden Anordnung von Ringspulen.

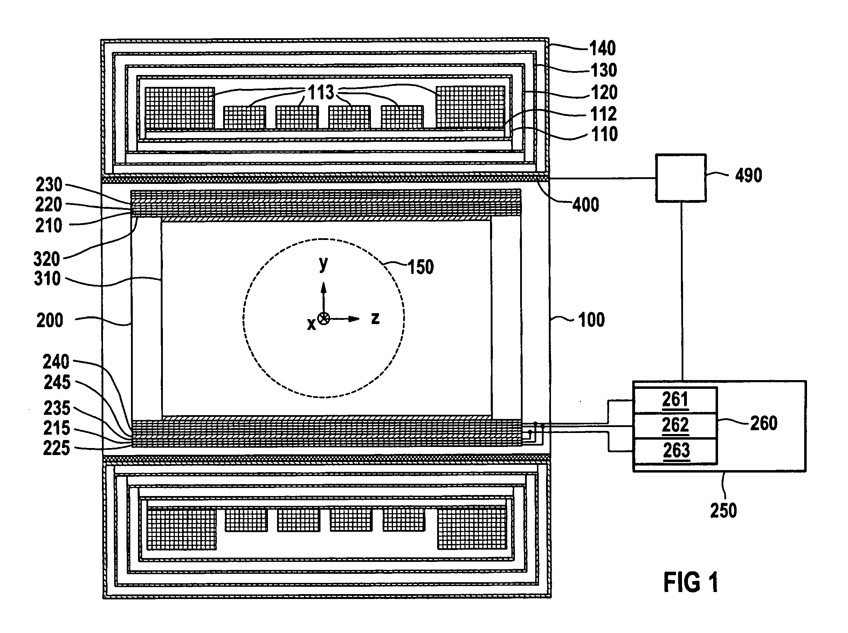

Die Figur 1 zeigt als ein Ausführungsbeispiel der Erfindung einen Längsschnitt durch ein Magnetresonanzgerät. Dabei umfasst das Magnetresonanzgerät einen im Wesentlichen hohlzylinderförmigen Grundfeldmagneten 100, mit dem wenigstens innerhalb eines Abbildungsvolumens 150 des Magnetresonanzgeräts ein möglichst homogenes statisches Grundmagnetfeld erzeugbar ist. Der Grundfeldmagnet 100 umfasst einen im Wesentlichen hohlzylinderförmigen Heliumbehälter 110 aus unmagnetischem rostfreiem Stahl, in dem auf einem Wicklungsträger 112 supraleitende Solenoidspulen 113 angeordnet sind, die von dem sie umgebenden flüssigen Helium auf 4,2 K gekühlt werden.

Der Heliumbehälter 110 ist von einem hohlzylinderförmigen 20-K-Kälteschild 120 umschlossen, das wiederum von einem hohlzylinderförmigen 80-K-Kälteschild 130 umschlossen ist. Die Kälteschilde 120 und 130 bewirken dabei, dass möglichst wenig Wärmestrahlung von außen bis zum Heliumbehälter 110 vordringt und sind aus einem gut wärmeleitenden Metall ausgeführt. Durch Kryokühler, Kaltgas oder flüssigen Stickstoff werden das 20-K-Kälteschild 120 auf einer Temperatur von 20 K und das 80-K-Kälteschild 130 auf einer Temperatur von 80 K gehalten.

Das 80-K-Kälteschild 130 ist schließlich von einem im Wesentlichen hohlzylinderförmigen Vakuumbehälter 140 aus unmagnetischem rostfreien Stahl umschlossen. Dabei sind der Heliumbehälter 110 mit dem 20-K-Kälteschild 120, die beiden Kälteschilde 120 und 130 untereinander und das 80-K-Kälteschild 130 mit dem Vakuumbehälter 140 schlecht wärmeleitend und auf gegenseitigen Abstand von einigen Millimetern bis wenigen Zentimetern, beispielsweise über dünne Glasfaserstäbe, verbunden.

Ferner umfast das Magnetresonanzgerät ein Gradientenspulensystem 200, das Gradienten- und zugehörige Abschirmspulen beinhaltet und dem eine Gradientensteuereinheit 250 zugeordnet ist. Dabei ist das im Wesentlichen hohlzylinderförmige Gradientenspulensystem 200 in der zylinderförmigen Höhlung des Vakuumbehälters 140 durch ein Verkeilen befestigt.

Zum Steuern von Strömen in den Spulen ist das Gradientenspulensystem 200 mit der Gradientensteuereinheit 250 verbunden. Mit dem bestromten Gradientenspulensystem 200 sind innerhalb des Abbildungsvolumens 150 dem Grundmagnetfeld schnell schaltbare magnetische Gradientenfelder überlagerbar.

Dabei umfasst das Gradientenspulensystem 200 von innen nach außen folgende hohlzylinderförmige Bereiche 210 bis 245, die konzentrisch zueinander angeordnet sind: Ein erster hohlzylinderförmiger Bereich 210 umfasst eine x-Gradientenspule zum Erzeugen eines x-Gradientenfeldes mit einem Gradienten kollinear zur x-Achse eines kartesischen Koordinatensystems. Ein zweiter hohlzylinderförmiger Bereich 220 beinhaltet eine y-Gradientenspule zum Erzeugen eines y-Gradientenfeldes mit einem Gradienten kollinear zur y-Achse. Die x- und die y-Gradientenspulen umfassen dabei jeweils vier sattelförmig ausgebildete Teilspulen. Ein dritter hohlzylinderförmiger Bereich 240 umfasst eine Kühleinrichtung, unter anderem zum Kühlen der Gradientenspulen. Ein vierter hohlzylinderförmiger Bereich 230 umfasst eine z-Gradientenspule zum Erzeugen eines z-Gradientenfeldes mit einem Gradienten kollinear zur z-Achse, wobei die z-Gradientenspule beispielsweise zwei Solenoid-Teilspulen umfasst.

Ein fünfter hohlzylinderförmiger Bereich 245 umfasst aktive und/oder passive Shimvorrichtungen und eine weitere Kühleinrichtung. In einem sechsten hohlzylinderförmigen Bereich 235 ist eine der z-Gradientenspule zugeordnete z-Abschirmspule angeordnet. Ein siebter hohlzylinderförmiger Bereich 215 umfasst eine x-Abschirmspule, die der x-Gradientenspule zugeordnet ist. Schließlich umfasst ein achter hohlzylinderförmiger Bereich 225 eine y-Abschirmspule, die der y-Gradientenspule zugeordnet ist.

Die den Gradientenspulen zugehörigen Abschirmspulen sind dabei derart gestaltet und bestrombar, dass die mit den Abschirmspulen erzeugbaren Magnetfelder die mit den zugehörigen Gradientenspulen erzeugbaren Magnetfelder auf dem inneren Zylindermantel des 80-K-Kälteschildes 130 wenigstens derart kompensieren, dass im inneren Zylindermantel durch das bestromte Gradientenspulensystem 200 gegenüber einem Gradientenspulensystem ohne Abschirmspulen weniger Wirbelströme induziert werden.

Damit die geschalteten Gradientenfelder im Abbildungsvolumen 150 nicht durch Wirbelstrominduktion und damit einhergehende Wirbelstrom-Magnetfelder verzerrt werden, wird in der Gradientensteuereinheit 250 mit entsprechend vorverzerrten Steuergrößen für die Ströme der Gradienten- und zugehörigen Abschirmspulen gearbeitet. Dazu weist die Gradientensteuereinheit 250 eine entsprechende Vorverzerrungseinheit 260 auf, die für jede der drei Gradientenachsen x, y und z eine eigene Vorverzerrungsuntereinheit 261, 262 und 263 aufweist.

Des Weiteren umfasst das Magnetresonanzgerät zum Einstrahlen von Hochfrequenzsignalen in ein im Abbildungsvolumen 150 gelagertes Untersuchungsobjekt sowie zum Aufnehmen von Magnetresonanzsignalen aus dem Untersuchungsobjekt eine Antenne 310. Dabei ist zum Abschirmen von äußeren Störeinflüssen zwischen der Antenne 310 und dem Gradientenspulensystem 200 ein Hochfrequenzschirm 320 angeordnet.

Des Weiteren umfasst das Magnetresonanzgerät einen Krafterzeuger 400, der als Hohlzylinder kleiner Wandstärke schichtartig an den inneren Zylindermantel des Vakuumbehälters 140 angefügt ist. Durch die geschalteten Gradientenfelder werden im inneren Zylindermantel des Vakuumbehälters 140 Wirbelströme induziert, auf die im Grundmagnetfeld Lorentzkräfte wirken, so dass ohne gegensteuernde Maßnahmen ein Verformen, Bewegen und/oder Schwingen des inneren Zylindermantels die Folge wäre. Der Krafterzeuger 400 ist dabei derart gestaltet und steuerbar, dass der Krafterzeuger 400 vorgenannten Lorentzkräften entgegenwirkende Kräfte erzeugen kann, so dass das Verformen, Bewegen und/oder Schwingen des inneren Zylindermantels verhindert wird. Für ein entsprechendes Ansteuern des Krafterzeugers 400 ist dem Krafterzeuger 400 eine Krafterzeugersteuereinheit 490 zugeordnet, die mit der Gradientensteuereinheit 250, insbesondere deren Vorverzerrungseinheit 260 verknüpft ist. Dabei ist die Vorverzerrung der Spulenströme zum Steuern des Krafterzeugers 400 nutzbar, da die Vorverzerrung den genauen Anteil und den Zeitverlauf der Wirbelströme wiederspiegelt.

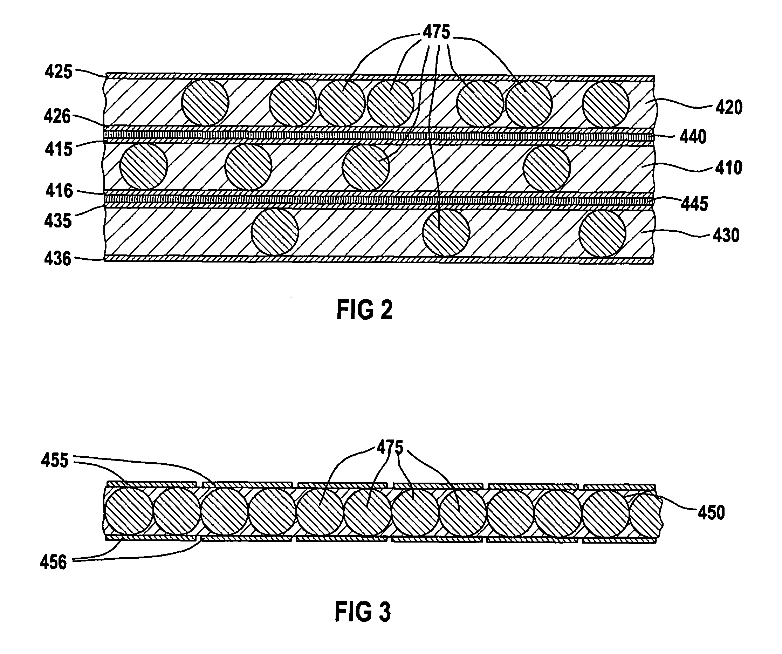

Die Figur 2 zeigt als ein Ausführungsbeispiel der Erfindung ausschnittsweise einen detaillierten Längsschnitt durch den Krafterzeuger 400 in einer ersten Ausführungsform. Der Krafterzeuger 400 umfasst dabei drei Schichten 410, 420 und 430, in denen elektrostriktive Fasern 475 oder ganze Bündel derartiger Fasern angeordnet sind. Dabei sind die elektrostriktiven Fasern 475 in der Schicht 430 entsprechend einer Ortsverteilung der am inneren Zylindermantel des Vakuumbehälters 140 angreifenden Lorentzkräfte angeordnet, die durch die bestromten z-Spulen verursacht werden. In den Schichten 420 und 410 sind dahingegen die elektrostriktiven Fasern 475 entsprechend den durch die bestromten x- und y-Spulen verursachten Lorentzkräfte angeordnet. Mit den elektrostriktiven Fasern 475 ist dabei mit Vorteil eine sehr feine Ortsauflösung erreichbar.

In anderen Ausführungsformen können anstelle der Fasern 475 auch folienartig, plattenartig und/oder stapelartig ausgebildete, elektrostriktive Elemente, wie auch magnetostriktive und/oder hydraulische Krafterzeuger eingesetzt werden.

Die elektrostriktiven Fasern 475 sind dabei je Schicht 410, 420 und 430 zwischen jeweils zwei Kontaktierungsschichten 415 und 416, 425 und 426 sowie 435 und 436 angeordnet. Zwischen den Kontaktierungsschichten 426 und 415 sowie 416 und 435 sind elektrisch isolierende Schichten 440 und 445 angeordnet. Zwischen den Kontaktierungsschichten 415 und 416, 425 und 426 sowie 435 und 436 sind elektrische Spannungen anlegbar, die eine Striktion der elektrostriktiven Fasern 475 und damit eine Kraft senkrecht zur Oberfläche des inneren Zylindermantels des Vakuumbehälters 140 bewirken.

Die elektrischen Spannungen werden dabei von der Krafterzeugersteuereinheit 490 bereitgestellt, wobei die Schicht 420 entsprechend einer Vorverzerrung für die y-Spulen durch die Vorverzerrungsuntereinheit 262, die Schicht 410 entsprechend einer Vorverzerrung für die x-Spulen durch die Vorverzerrungsuntereinheit 261 und die Schicht 430 entsprechend einer Vorverzerrung für die z-Spulen durch die Vorverzerrungsuntereinheit 263 gesteuert werden.

Die Figur 3 zeigt als ein weiteres Ausführungsbeispiel der Erfindung ausschnittsweise einen detaillierten Längsschnitt durch den Krafterzeuger 400 in einer zweiten Ausführungsform. Dabei sind in einer Schicht 450 elektrostriktive Fasern 475 gleichverteilt angeordnet. Die Schicht 450 ist dabei zwischen zwei Kontaktierungsschichten 455 und 456 angeordnet, wobei die beiden Kontaktierungsschichten 455 und 456 in übereinstimmender Weise in Teilkontaktierungen unterteilt sind. Die Teilkontaktierungen sind voneinander isoliert und die Schicht 450 parkettartig bedeckend angeordnet. Dabei bilden jeweils zwei Teilkontaktierungen, die sich bezüglich der Schicht 450 gegenüberliegen ein Paar. Mit der Krafterzeugersteuereinheit 490 ist an jedes der Paare eine elektrische Spannungen anlegbar, wobei für jedes der Paare die Spannung unabhängig von den Spannungen an anderen Paaren einstellbar ist. Damit sind in der Schicht 450 entsprechende Bereiche einer oder mehrerer der elektrostriktiven Fasern 475 unabhängig voneinander und mit unterschiedlichen Striktionen steuerbar.

Gegenüber der ersten Ausführungsform ist mit Vorteil die Schichtdicke des Krafterzeugers 400 reduziert, dafür sind die vielen Teilkontaktierungen separat und in der Regel mit unterschiedlichen Spannungen anzusteuern. Dabei können für ein wirkungsgleiches Ansteuern wie bei der ersten Ausführungsform die Vorverzerrungen der einzelnen Vorverzerrungsuntereinheiten 261, 262 und 263 nicht unmittelbar verwendet werden, sondern sind in der Krafterzeugersteuereinheit 490 zunächst weiterzuverarbeiten und auf die einzelnen Teilkontaktierungen umzusetzen. Für das Weiterverarbeiten sind dabei die prinzipiellen Lorentzkräfte-Ortsverteilungen, die jede der Spulen auf dem inneren Zylindermantel des Vakuumbehälters 140 hervorruft, beispielsweise durch Messung zu ermitteln und in der Krafterzeugersteuereinheit 490 zu speichern. Des Weiteren kann bei der zweiten Ausführungsform aufgrund der vielen Teilkontaktierungen örtlich unterschiedlichen Abklingzeiten von Wirbelströmen, die in unterschiedlichen Bereichen des inneren Zylindermantels vorherrschen, durch ein entsprechendes Ansteuern Rechnung getragen werden.

In anderen Ausführungsformen sind die erste und die zweite Ausführungsform miteinander kombiniert. So kann beispielsweise vorgenannten unterschiedlichen Abklingzeiten bei der ersten Ausführungsform dadurch Rechnung getragen werden, dass auch die Kontaktierungsschichten 415, 416, 425, 426, 435 und 436 in wenigstens einige Teilkontaktierungen unterteilt werden.

Das zusätzliche Gewicht des Krafterzeugers 400 verändert die im inneren Zylindermantel des Vakuumbehälters 140 auftretenden Lorentzkräfte nicht und die dünnen leitfähigen Kontaktierungsschichten 415, 416, 425, 426, 435, 436, 455 und 456 des Krafterzeugers 400, die ihrerseits eine für Wirbelstrominduktion leitfähige Struktur darstellen, verändern allenfalls eine Amplitude der am inneren Zylindermantel zu kompensierenden Lorentzkräfte.

Für eine Feinabstimmung in der Krafterzeugersteuereinheit 490 können zusätzlich zu den gespeicherten Informationen und den Informationen aus der Vorverzerrungseinheit 260 auch die von den einzelnen Gradienten- und zugehörigen Abschirmspulen erzeugten, wirbelstromverursachenden Magnetfelder wenigstens punktuell gemessen und als skalierende Größe der Krafterzeugersteuereinheit 490 zugeführt werden. Dabei ist es ausreichend, lediglich die radial gerichtete Komponente der Magnetfelder zu erfassen, da nur diese Wirbelströme hervorruft. Dabei sind von diesen so angeregten Wirbelströmen nur die Ströme in Umfangsrichtung wesentlich, da nur auf diese die Lorentzkräfte in radialer Richtung wirken, was ohne die gegensteuernde Maßnahme des Krafterzeugers 400 zum Schwingen des Vakuumbehälters 140 führen würde und damit Lärm und weitere, sekundäre Wirbelströme verursachen würde.

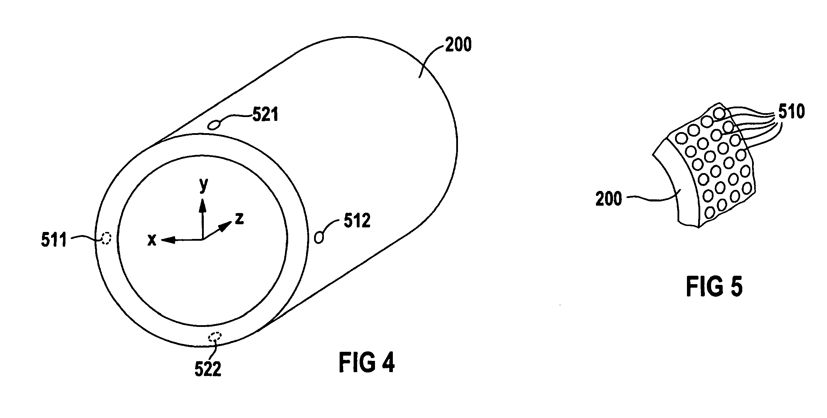

Die Figur 4 zeigt eine perspektivische Ansicht des Gradientenspulensystems 200 mit vier am Gradientenspulensystem 200 befestigten Ringspulen 511, 512, 521 und 522, wobei die Ringspulen 511, 512, 521 und 522 bezüglich der z-Richtung gleichpositioniert, die Ringspulen 511 und 512 in einer y-z-Ebene und die anderen Ringspulen 521 und 522 in einer x-z-Ebene angeordnet sind.

Die Ringspulen 511 und 512 sind dabei in einem Bereich des Gradientenspulensystems 200 angeordnet, in dem die y-Spulen aufgrund ihrer Symmetrieeigenschaften unabhängig von ihrem Betriebszustand keine radial gerichtete Magnetfeldkomponente produzieren. Die Ringspulen 521 und 522 sind in einem entsprechenden Bereich der x-Spulen angeordnet. Die vier Ringspulen 511, 512, 521 und 522 sind ausreichend um die radial gerichteten Magnetfeldkomponenten der Gradienten- und zugehörigen Abschirmspulen entsprechend der einzelnen Achsen x, y und z voneinander separierbar zu erfassen. So bedeutet beispielsweise ein gleich großes Signal an allen Ringspulen 511, 512, 521 und 522, dass lediglich die z-Spulen eine radial gerichtete Magnetfeldkomponente produzieren. Sind dagegen die Signale der beiden Ringspulen 511 und 512 unterschiedlich, so bedeutet dies, dass die Differenz auf eine radial gerichtete Magnetfeldkomponente der x-Spulen zurückgeht. Ein Unterschied zwischen den Signalen der beiden Ringspulen 521 und 522 charakterisiert dabei einen von den y-Spulen herrührenden Beitrag.

Die Figur 5 zeigt als ein weiteres Ausführungsbeispiel der Erfindung eine flächendeckende Anordnung von Ringspulen 510 auf der Oberfläche des Gradientenspulensystems 200. Dabei ist jede der Ringspulen 510 beispielsweise entsprechend einer Teilkontaktierung der Figur 3 angeordnet und jeweils einer der Teilkontaktierungen zugeordnet. Die Ringspulen 510 sind dabei ähnlich den Ringspulen 511, 512, 521 und 522 der Figur 4 lediglich zum Erfassen von radial gerichteten Magnetfeldkomponenten ausgebildet. Mit dem Messsignal einer jeden der Ringspulen 510 ist die jeweils zugehörige Teilkontaktierung ansteuerbar. Eine Ansteuerung auf Basis der Vorverzerrung und ebenso ein Separieren der Magnetfeldkomponenten hinsichtlich den Achsen x, y und z ist damit verzichtbar.

In anderen Ausführungsformen können dabei anstelle von Ringspulen andere Sensoren, die sensitiv auf die von den Gradienten- und zugehörigen Abschirmspulen erzeugten Magnetfelder und insbesondere nicht sensitiv auf Vibrationen sind, beispielsweise Hallsonden, eingesetzt werden.

In einer wiederum anderen Ausführungsform können die im Zylindermantel des Vakuumbehälters oder in den Kontaktierungsschichten 455 oder 456 auftretenden Wirbelströme direkt erfasst werden und zum Ansteuern des Krafterzeugers 400 in der zweiten Ausführungsform nach Figur 3 verwendet werden. Da dabei ausschließlich die Wirbelströme erfasst und nicht die Magnetfelder der Gradienten- und zugehörigen Abschirmspulen miterfasst werden sollen, können die Wirbelströme, beispielsweise aufgrund ihrer thermischen Wirkung, erfasst werden, wobei die Erfassungsergebnisse in entsprechende elektrische Spannungen für die Teilkontaktierungen umzuwandeln sind.

## Patentansprüche

1. Magnetresonanzgerät mit
- einem Grundfeldmagneten (100) zum Erzeugen eines Grundmagnetfeldes,
- wenigstens einem Wirbelstromerzeuger (200) und
- wenigstens einer elektrisch leitfähigen Struktur (140), in der durch den Wirbelstromerzeuger (200) Wirbelströme hervorrufbar sind, so dass auf die Struktur (140) im Grundmagnetfeld Lorentzkräfte wirken,
**dadurch gekennzeichnet,**
- **dass** an der Struktur (140) ein Krafterzeuger (400) angebracht ist,
- **dass** der Krafterzeuger (400) derart ausgebildet und steuerbar ist, dass mit dem Krafterzeuger (400) den Lorentzkräften entgegenwirkende Kräfte erzeugt werden, so dass ein Bewegen und Verformen der Struktur (140) verhindert wird.

2. Magnetresonanzgerät nach Anspruch 1, **dadurch gekennzeichnet, dass** eine Steuerung (490) des Krafterzeugers (400) mit einer Steuerung (250) des Wirbelstromerzeugers (200) verbunden ist.

3. Magnetresonanzgerät nach einem der Ansprüche 1 oder 2, **dadurch gekennzeichnet, dass** der Wirbelstromerzeuger (200) wenigstens eine Spulenanordnung (210, ..., 245) zum Erzeugen eines Gradientenfeldes umfasst.

4. Magnetresonanzgerät nach Anspruch 3, **dadurch gekennzeichnet, dass** eine Steuerung der Spulenanordnung (250) eine Vorverzerrungseinheit (260) umfasst, die mit der Steuerung des Krafterzeugers (490) verbunden ist.

5. Magnetresonanzgerät nach einem der Ansprüche 1 bis 4, **dadurch gekennzeichnet, dass** die Struktur wenigstens Teile eines Vakuumbehälters (140), eines Kälteschildes (120, 130) und/oder eines Kühlmittelbehälters (110) des Grundfeldmagneten (100) umfasst.

6. Magnetresonanzgerät nach einem der Ansprüche 1 bis 5, **dadurch gekennzeichnet, dass** die Struktur wenigstens Teile einer Antenne (310) und/oder eines Hochfrequenzschirms (320) umfasst.

7. Magnetresonanzgerät nach einem der Ansprüche 1 bis 6, **dadurch gekennzeichnet, dass** der Krafterzeuger (400) elektrostriktive Elemente (475) umfasst.

8. Magnetresonanzgerät nach Anspruch 7, **dadurch gekennzeichnet, dass** die elektrostriktiven Elemente (475) räumlich mit einer Dichte entsprechend einer relativen Dichte der Lorentzkräfte angeordnet sind.

9. Magnetresonanzgerät nach einem der Ansprüche 7 oder 8, **dadurch gekennzeichnet, dass** die elektrostriktiven Elemente (475) faserartig ausgebildet sind.

10. Magnetresonanzgerät nach einem der Ansprüche 1 bis 9, **dadurch gekennzeichnet, dass** das Magnetresonanzgerät Sensoren umfasst, mit denen ein vom Wirbelstromerzeuger erzeugbares Magnetfeld erfasst wird.

11. Magnetresonanzgerät nach Anspruch 10, **dadurch gekennzeichnet, dass** die Sensoren zum Skalieren und/oder Bestimmen einer Steuerung des Krafterzeugers (400) mit dem Krafterzeuger verbunden sind.

## Claims

1. A magnetic resonance apparatus with:
- a basic field magnet (100) for generating a basic magnetic field;
- at least one eddy current generator (200) and
- at least one electrically conductive structure (140) in which eddy currents can be generated by the eddy current generator (200), so that Lorentz forces act on the structure (140) in the basic magnetic field,
**characterised in that**
- a force generator (400) is attached to the structure (140),
- the force generator (400) is embodied and able to be controlled so that forces counteracting the Lorentz forces are created with the force generator (400) so that a movement and deformation of the structure (140) is prevented.

2. Magnetic resonance apparatus according to claim 1, **characterised in that** a control unit (490) of the force generator is connected to a control unit (250) of the eddy current generator (200).

3. Magnetic resonance apparatus according to one of claims 1 or 2, **characterised in that** the eddy current generator (200) comprises at least one coil arrangement (210, ..., 245) for generating a magnetic gradient field.

4. Magnetic resonance apparatus according to claim 3, **characterized in that** a control unit of the coil arrangement (250) comprises a predistortion unit (260) which is connected to a control unit of the force generator (490).

5. Magnetic resonance apparatus according to one of claims 1 to 4, **characterised in that** the structure comprises at least parts of a vacuum vessel (140), a cryoshield (120, 130) and/or a coolant vessel (110) of the basic field magnet (100).

6. Magnetic resonance apparatus according to one of claims 1 to 5, **characterised in that** the structure comprises at least a parts of an antenna (310) and/or a radio-frequency shield (320).

7. Magnetic resonance apparatus according to one of claims 1 to 6, **characterised in that** the force generator (400) comprises electrostrictive elements (475).

8. Magnetic resonance apparatus according to claim 7, **characterised in that** the electrostrictive elements (475) are spatially disposed with a density corresponding to a relative density of the Lorentz forces.

9. Magnetic resonance apparatus according to one of claims 7 or 8, **characterised in that** the electrostrictive elements (475) are embodied as fibres.

10. Magnetic resonance apparatus according to one of claims 1 to 9, **characterised in that** the magnetic resonance apparatus includes sensors with which a magnetic field able to be generated by the magnetic resonance apparatus is detected.

11. A magnetic resonance apparatus according to claim 10, **characterised in that** the sensors for scaling and/or determination of a control unit of the force generator (400) are connected to the force generator.

## Revendications

1. Appareil à résonance magnétique comprenant
- un aimant à champ de base (100) pour générer un champ magnétique de base,
- au moins un générateur de courant de Foucault (200) et
- au moins une structure (140) électroconductrice, dans laquelle des courants de Foucault peuvent être provoqués par le générateur de courant de Foucault (200) , de sorte que des forces de Lorentz agissent sur la structure (140) dans le champ magnétique de base,
**caractérisé en ce que**
- un générateur de force (400) est placé sur la structure (140),
- le générateur de force (400) est réalisé et peut être commandé de telle sorte que des forces agissant dans le sens contraire aux forces de Lorentz sont générées avec le générateur de force (400), de sorte qu'un déplacement et une déformation de la structure (140) sont empêchés.

2. Appareil à résonance magnétique selon la revendication 1, **caractérisé en ce qu'**une commande (490) du générateur de force (400) est reliée à une commande (250) du générateur de courant de Foucault (200).

3. Appareil à résonance magnétique selon l'une quelconque des revendications 1 ou 2, **caractérisé en ce que** le générateur de courant de Foucault (200) comporte au moins un agencement de bobines (210, ..., 245) pour générer un champ de gradient.

4. Appareil à résonance magnétique selon la revendication 3, **caractérisé en ce qu'**une commande de l'agencement de bobines (250) comporte une unité de pré-distorsion (260) qui est reliée à la commande (490)du générateur de force.

5. Appareil à résonance magnétique selon l'une quelconque des revendications 1 à 4, **caractérisé en ce que** la structure comporte au moins des parties d'un réservoir à vide (140), d'un bouclier thermique (120, 130) et/ou d'un réservoir de réfrigérant (110) de l'aimant à champ de base (100).

6. Appareil à résonance magnétique selon l'une quelconque des revendications 1 à 5, **caractérisé en ce que** la structure comporte au moins des parties d'une antenne (130) et/ou d'un bouclier haute fréquence (320).

7. Appareil à résonance magnétique selon l'une quelconque des revendications 1 à 6, **caractérisé en ce que** le générateur de force (400) comporte des éléments électrostrictifs (475).

8. Appareil à résonance magnétique selon la revendication 7, **caractérisé en ce que** les éléments électrostrictifs (475) sont disposés dans l'espace avec une densité correspondant à une densité relative des forces de Lorentz.

9. Appareil à résonance magnétique selon l'une quelconque des revendications 7 ou 8, **caractérisé en ce que** les éléments électrostrictifs (475) ont une configuration de type fibre.

10. Appareil à résonance magnétique selon l'une quelconque des revendications 1 à 9, **caractérisé en ce que** l'appareil à résonance magnétique comporte des capteurs avec lesquels un champ magnétique pouvant être généré par le générateur de courant de Foucault est détecté.

11. Appareil à résonance magnétique selon la revendication 10, **caractérisé en ce que** les capteurs sont reliés au générateur de force pour l'ajustement et/ou la détermination d'une commande du générateur de force (400).
